# EUROPEAN PATENT SPECIFICATION

(11) **EP 0 336 515 B1**
(45) Date of publication and mention of the grant of the patent: **17.10.2001**
(21) Application number: 89200845.9
(22) Date of filing: 03.04.1989
(51) Int. Cl.: H01L 21/762, H01L 21/32

(54) **Method of manufacturing a semiconductor device having a silicon substrate with fully or partly sunken field oxide regions**
Verfahren zum Herstellen einer Halbleiteranordnung mit einem Siliziumsubstrat mit völlig oder teilweise versenkten Feldoxidigebieten
Procédé de fabrication d'un dispositif semiconducteur muni d'un substrat de silicium présentant des régions d'oxyde d'isolement en tout ou en partie noyées

(30) Priority: 08.04.1988 NL 8800903
(43) Date of publication of application: 11.10.1989
(73) Proprietor: Koninklijke Philips Electronics N.V., 5621 BA Eindhoven (NL)
(72) Inventor: Lifka, Herbert, NL-5656 AA Eindhoven (NL); Woerlee, Pierre Hermanus, NL-5656 AA Eindhoven (NL)
(74) Representative: Duijvestijn, Adrianus Johannes

(56) References cited:
- EP-A- 0 071 203
- EP-A- 0 166 474
- EP-A- 0 189 795
- EP-A- 0 208 356
- GB-A- 2 083 947
- US-A- 4 038 110
- IEEE TRANSACTIONS ON ELECTRON DEVICES, vol. 35, no. 3, March 1988, pages 275-284, IEEE, New York, US; H.-H. TSAI et al.: "An evaluation of FUROX isolation technology for VLSI/nMOSFET fabrication"
- IEEE ELECTRON DEVICE LETTERS, vol. EDL-7, no. 2, February 1986, pages 122-123, IEEE, New York, US; H.-H. TSAI et al.: "A bird's beak reduction technique for LOCOS VLSI fabrication"
- INTERNATIONAL ELECTRON DEVICES MEETING 1983, Washington, DC, 5th-7th December 1983, pages 757-759, IEEE, New York, US; T. KURE et al.: "VLSI device fabrication using a unique highly-selective Si3N4 dry etching"
- A E T KUIPER: "Hydrogenation during thermal nitridation of silicon dioxide", J. APPL PHYS, , 15. April 1986, vol. 59, no. 8, pages 2765 to 2772

## Description

The invention relates to a method of manufacturing a semiconductor device comprising a silicon substrate with fully or partly sunken field oxide regions for mutual insulation of semiconductor elements to be formed in the substrate, in which method a mask is formed in a layer of silicon oxynitride (SiOₓN_{y}) deposited upon a surface of the substrate and an overlying layer of silicon nitride (Si₃N₄), whereby in the layer of silicon oxynitride x/y is smaller than 0.5, after which, using said mask, recesses are first provided in the substrate in which recesses the field oxide regions are then formed by subjecting the recesses over their whole area to an oxidation treatment.

Such a method is suitable in particular for manufacturing semiconductor devices having such a flat topography that the wiring tracks for connecting and interconnecting the semiconductor elements to be formed in the silicon substrate, including transistors and diodes, can be provided comparatively simply on a substantially flat surface.

A method of the type mentioned in the opening paragraph is known from European Patent Application EP-A 0,071,203 in which the recesses in the substrate are provided by wet etching with a solution of chromium trioxide and hydrogen fluoride.

In the isotropic etching treatment of the substrate in such a manner silicon is etched away in the regions of the substrate determined for that purpose by apertures of the mask not only in the direction perpendicular to the surface hereof but also in the lateral direction, i.e. beyond the edges of the apertures in the regions of the substrate covered by the mask. The recesses thus formed hence extend also in the "active" regions of the substrate cover with the mask where the semiconductor elements are provided. After the oxidation to be performed subsequently the ultimately formed field oxide regions will extend undesirably in the said active regions as a result of lateral growth of silicon oxide.

For illustration, for the formation according to this known method of sunken field oxide regions having a thickness of approximately 400 nm measured in the direction perpendicularly to the substrate surface, which is a conventionally used dimension in sub-micron semiconductor technology, first approximately 200 nm deep recesses are etched in the substrate and the sunken field oxide regions are then formed in the said recesses by oxidation. Because silicon oxide, compared with silicon, has a substantially twice as large specific volume, the ultimately formed field oxide regions will extend deeper in the substrate over a distance of approximately 200 nm than the recesses formed herein.

As a result of the isotropic etching, however, silicon is also removed over a distance comparable with the depth of the recesses to be formed beyond the edge of the apertures of the mask. As a result of the lateral growth of silicon oxide the ultimately formed field oxide regions will extend in the active regions of the substrate over a distance of more than 300 nm beyond the edge of the apertures of the mask. This phenomenon is sometimes termed undergrowth.

An undergrowth of this order of magnitude approaches the dimensions of the active regions conventionally used in sub-micron semiconductor technology, which means that, with a view to the loss of area as a result of the comparatively strong undergrowth, the known method in itself is unfit for use in sub-micron semiconductor technology. Because furthermore it is very difficult in practice to etch a wafer throughout its surface with everywhere the same depth, an undesired margin with respect to the dimensions of the active regions of the substrate will have to be calculated in the design of the mask. Inter alia as a result of this the integration density of the semiconductor device is restricted. The chromium used in the etching solution further has an unfavorable influence on the quality of the ultimate semiconductor device.

In the publication "An evaluation of FUROX isolation technology for VLSI/nMOSFET fabrication" of Tsai et al, published in IEEE Transactions on Electron Devices, Vol. 35, No. 3, March 1988, pg. 275-284, a similar method is described, in which instead of an silicon oxynitride layer an silicon oxide layer has been deposited and this silicon oxide layer has been thermally nitridized in an ammonia ambient at 1200 °C for 7 hours.

It is the object of the invention to provide a method of the type mentioned in the opening paragraph having an undergrowth which is smaller compared with the known method and without the necessity of using etching solutions which detrimentally influence the quality of the semiconductor device.

A method in accordance with the invention is characterized in that the recesses are provided in the substrate by performing a first oxidation and then etching away the silicon oxide thus formed, and in that prior to performing the first oxidation step a further layer of silicon oxynitride (SiOₓN_{y}) is provided on the mask after which the said further layer of silicon oxynitride is etched anisotropically in such a manner that the edges of the apertures of the mask which bound the regions of the substrate where the recesses are provided remain covered with parts of the said further layer of silicon oxynitride.

It has been found that while using the method according to the invention a considerably smaller undergrowth of the field oxide regions occurs than in the known method.

For illustration, for the formation of approximately 400 nm deep sunken field oxide regions a first layer of silicon oxide having a thickness of approximately 400 nm is formed while using the method according to the invention so as to extend over a depth of approximately 200 nm in the substrate. For the removal of the silicon oxide the assembly is then subjected to a dry etching treatment after which the ultimate sunken field oxide regions are formed in the approximately 200 nm deep recesses thus formed.

As a result of the applied mask of silicon oxynitride and silicon nitride the lateral undergrowth in the first oxidation step is comparatively small, approximately 50 nm. Due to this comparatively small undergrowth the mask provides also during the second oxidation step such a screening activity that the field oxide regions formed ultimately extend in the active regions of the substrate in this example over a distance of approximately 150 nm measured from the edge of the apertures of the mask. Compared with the known method the lateral oxide growth with the method according to the invention is reduced by at least a factor two.

A further advantage of the invention resides in the fact that the oxidation occurs very homogeneously over the substrate surface and that the formed silicon oxide can be etched selectively with respect to the silicon. This means a comparatively time-independent process in which, in contrast with the etching of silicon as in the known method, more homogeneous and accurate recesses can be formed. Since no chromium solution need be used for etching silicon oxide, the ultimate semiconductor device will be of comparatively better quality than a semiconductor device manufactured while using the known method.

It is to be noted that the formation of field oxide regions by means of two oxidation steps is known per se, for example, from Japanese Patent Application 56/43744 (A). In this application the oxidation steps are carried out with a mask consisting of a first layer of silicon oxide directly adjoining the surface of the substrate and an overlying second layer of silicon nitride. During the formation of, for example, 400 nm thick sunken field oxide regions, via approximately 200 nm deep recesses, while masking the mask suggested in accordance with the method according to the said Japanese Patent Application, a lateral oxide growth of approximately 400 nm occurs during the two oxidation steps so that the ultimately formed field oxide regions extend in the active regions of the substrate over a distance of approximately 800 nm beyond the edge of the apertures of the mask. In contrast with the method according to the invention the formation in two oxidation steps of sunken field oxide regions in accordance with the said Japanese Patent Application does not at all provide the desired reduction of the lateral oxide growth.

In accordance with the preferred embodiment of the method according to the invention the mask is provided as a 30 to 60 nm thick layer of silicon oxynitride and a 50 to 200 nm thick layer of silicon nitride. These layer thicknesses protect the substrates sufficiently from undesired oxidation or etching, as well as from crystal imperfections as a result of mechanical stresses exerted during the various manufacturing steps of the semiconductor device on layers provided on said surface. The recesses in the mask may be formed in known manner, for example, by means of photolithographic techniques.

In the method according to the invention the lateral oxide growth may be reduced in that prior to performing the first oxidation step a further layer of silicon oxynitride (SiOₓN_{y}) is provided on the mask after which the said further layer of silicon oxynitride is etched anisotropically in such a manner that the edges of the aperture of the mask which bound the regions of the substrate where the recesses are provided remain covered with parts of the said further layer of silicon oxynitride.

With these parts formed according to the invention, which are sometimes termed "spacers" in the English technical literature, it is at least achieved that no or substantially no oxidizing particles can penetrate from the apertures of the mask into the active regions via the edge regions adjoining the substrate.

In the first oxidation step a layer of silicon oxide is formed having a thickness smaller than the thickness of the silicon oxide layer which is formed with the oxidation step for the formation of the field oxide regions.

The silicon oxide layer formed with the first oxidation step is etched away isotropically in a buffer solution of one part of hydrogen fluoride (HF) in seven parts of ammonium fluoride (NH₄F). This solution has such an etching selectivity that the silicon oxide is etched approximately six times faster than the silicon oxynitride.

By providing the further layer of silicon oxynitride with a thickness of 40 to 60 nm a sufficient coating of the edges of the apertures of the mask can be reached. The use of silicon oxynitride has the advantage that it can readily absorb mechanical stresses and that the remaining parts thereof are reduced in dimension upon etching the silicon oxide. This has the further advantage that during the oxidation step for the formation of the field oxide regions the apertures of the mask have such dimensions that the oxidizing gas mixture can relatively easily penetrate to the silicon.

Because the semiconductor wafer is generally subjected to several manufacturing steps for providing therein the various semiconductor elements after the field oxide regions have been formed, in which inter alia silicon oxide is also etched, the thickness of the field oxide regions may in practice decrease by approximately 100 nm.

However, by causing the formed field oxide regions to project over the substrate over a given distance, a structure having a substantially flat topography is obtained after providing the semiconductor elements on which structure, as mentioned in the opening paragraph, the wiring tracks of the semiconductor device can be provided in a comparatively simple manner.

Again while assuming that partly sunken field oxide regions should be formed which extend in the silicon substrate over a depth of approximately 400 nm and moreover project over the substrate surface by approximately 100 nm, according to the further method of the invention a first oxide layer is formed having a thickness of approximately 300 nm and after etching a further oxide layer of approximately 500 nm is formed. This in contrast with the preceding paragraph in which two oxidation steps of each approximately 400 nm were carried out. The oxide layers may be formed by subjecting the silicon substrate in a heated atmosphere to a gas mixture with oxygen and water.

Because the oxide layer formed with the first oxidation step now extends over a smaller depth in the substrate, the lateral growth hereof will also be less so that the recesses formed after the etching extend less beyond the edges of the apertures of the mask than in a first oxide layer of approximately 400 nm thickness. This means that the mask in the oxidation step for the formation of the field oxide regions provides a comparatively better protection so that the ultimate lateral oxide growth in this example is less than approximately 100 nm.

The ultimate loss of size as a result of lateral oxide growth in the active regions of the silicon substrate with respect to the dimensions of the oxidation mask is less than 50 nm when the spacers are used. Such an accurate dimensioning enables inter alia to further increase the integration density of the substrate.

The invention will now be described in greater detail with reference to an embodiment and the drawing, in which

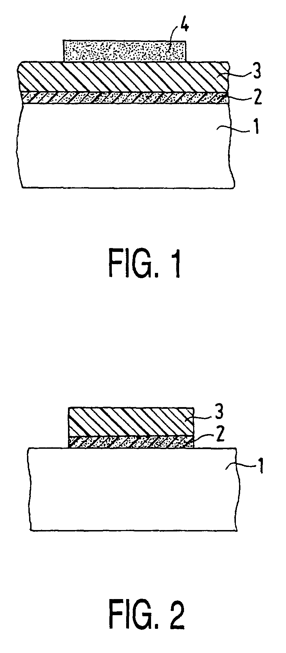

Figs. 1 to 7 are diagrammatic cross-sectional views, not drawn to scale, of a semiconductor substrate during the various manufacturing steps according to the method according the invention.

Fig. 1 shows a silicon substrate 1 on a surface of which a layer 2 of silicon oxynitride (SiOₓN_{y}) extends on which a layer 3 of silicon nitride (Si₃N₄) is provided. The layer 3 of silicon nitride may be provided, for example, while using conventionally used low-pressure vapor deposition techniques. The layer 2 of silicon oxynitride which is denoted by the chemical formula SiOₓN_{y} may be formed, for example, by simultaneous deposition of silicon nitride and silicon oxide. Such a layer may be considered as an oxygen-containing silicon nitride layer. The ratio x : y is smaller than 0.5, the protecting effect upon oxidizing the silicon substrate being comparable to that of a layer of silicon nitride of the same thickness.

The thickness of the layer 3 of silicon nitride should be chosen to be so that the underlying surface of the substrate 1 is protected from undesired oxidation. For carrying out the method according to the invention a layer thickness of the order of magnitude of 50 to 200 nm is sufficient. The layer 2 of silicon oxynitride must be sufficiently thick to protect the substrate 1 from undesired mechanical stresses caused by the layer 3 of silicon nitride. In accordance with the invention a thickness of approximately 30 to 60 nm is sufficient for this purpose.

A pattern 4 of photolacquer to form the mask is then provided on the layer 3 of silicon nitride in a manner known in practice, for example, by means of photolithographic techniques, by locally etching away the layer 3 of silicon nitride and the layer 2 of silicon oxynitride down to the substrate surface. Etching may be carried out, for example, in known manner with a fluorine-containing plasma. After the etching treatment the layer 4 of photolacquer is removed in a manner known in practice, so that, for example, the structure shown in Fig. 2 is obtained.

**According to an embodiment of the invention a** reduction of the lateral oxide growth can be produced by covering the edges of the apertures of the mask with the spacers already mentioned hereinbefore, before the first oxidation step is carried out for the formation according to the invention of the recesses in the substrate.

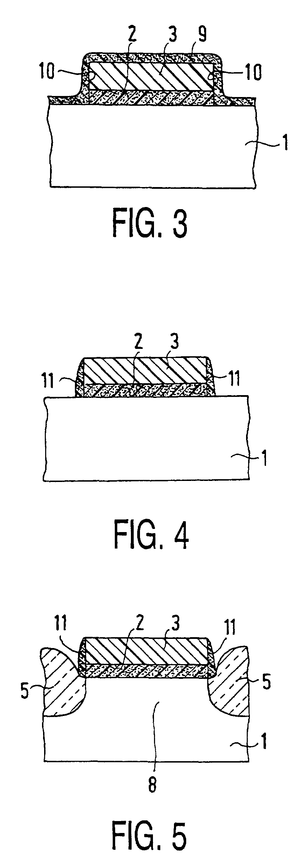

For the formation of the said spacers, according to the invention the mask is covered with a further layer of silicon oxynitride, as is shown in Fig. **3**, which further layer is etched selectively by means of a fluorine-containing plasma in such a manner that the side walls 10 of the apertures of the mask remain covered with parts 11 (spacers) of the said further layer 9 of silicon oxynitride, as is shown in Fig. **4**.

The dimensions of the spacers 11 near the substrate surface should be such that the undergrowth of the first oxide layer 5 to be formed again according to the invention is restricted to below the said spacers 11, as is shown in Fig. **5**. The thickness of the said further layer 9 of silicon oxynitride can be restricted according to the invention to approximately 40 to 60 nm.

After the formation of the mask **and the spacers** the exposed parts of the substrate surface are subjected according to the invention to a first oxidation treatment, for example, by heating the semiconductor wafer in a quartz tube to 900-1100 °C and leading a gas mixture consisting of hydrogen and an excess of oxygen over the semiconductor wafer. As a result of the comparatively high temperature water is formed, which results in a gas mixture with oxygen and water with which the silicon is oxidized.

Assuming that sunken oxide layers should be formed which extend over a depth of approximately 400 nm into the substrate, according to the method of the invention a first oxide layer 5 is formed in a thickness of approximately 400 nm as is shown in Fig. **5**. The silicon oxide as a result of its specific volume which is approximately two times larger than the silicon, extends for substantially half its thickness in the substrate and for the other half above the substrate surface. As a result of the comparatively small depth of penetration of the said first oxide layer 5 into the substrate the lateral growth of the said oxide layer in the active regions 8 of the substrate screened by the mask is restricted to approximately 50 nm, measured from the edge of the apertures of the mask, also while using the mask of silicon oxynitride and silicon nitride.

The first oxide layer 5 thus formed is then subjected according to the invention to an isotropic etching treatment, preferably by means of a buffer solution of one part of hydrogen fluoride (HF) in seven parts of ammonium fluoride (NH₄F). This buffer solution has such an etching selectivity that the silicon oxide is etched away approximately six times faster than the silicon oxynitride.

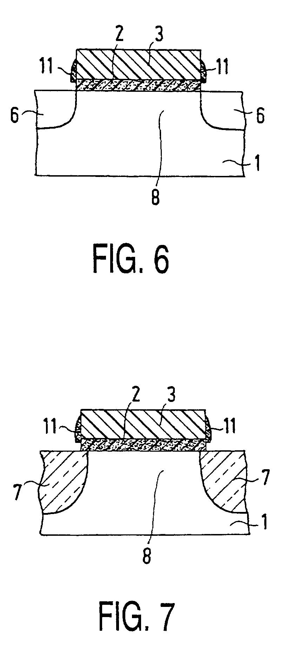

After the first oxide layer has been etched away a structure as shown in Fig. **6**. is formed in which at the area of the oxide layer 5 an approximately 200 nm deep recess 6 is formed in the substrate. As a result of the isotropic etching of the first oxide layer 5 a recess without sharp corners or edges is obtained, which is of advantage with respect to the mechanical properties of the semiconductor device as a whole.

Since the etching of silicon oxide is a process which can readily be controlled in practice, according to the invention recesses are formed which extend only over a distance of approximately 50 nm in the active regions of the substrate. Because as a result of the etching of the silicon oxide the silicon is substantially not attacked, the quality of the ultimately formed semiconductor device will be better than that of a semiconductor device obtained while using the known method in which etching is carried out with a solution of chromium.

By etching the first oxide layer 5, according to the method of the invention, for the formation of the recesses 6 the dimensions of the spacers 11 will also decrease, for example, as is shown in Fig. **6**.

After the recesses formed according to the method of the invention have been provided in the substrate the assembly is subjected to a second oxidation treatment by means of the said oxidizing gas mixture in which the partly sunken field oxide regions 7 are formed in a total thickness of approximately 400 nm, as is shown in Fig. **7**. Due to the reduced dimensions of the spacers 11 the recesses 6 formed in the substrate 1 can readily be reached for the oxidizing gas mixture with which the sunken field oxide regions 7 are formed. The ultimately formed field oxide regions now show an undergrowth in the active regions 8 of less than 50 nm. As a result of this small deviation in dimension the ultimately formed active regions 8 correspond to a sufficient extent to the dimensions of the mask, which enables the manufacture of a semiconductor device with comparatively small active regions, as is required for increasing the integration density.

The thickness of the field oxide regions is determined by the required electric insulation between the active regions of the substrate. It will be obvious that in practice other layer thicknesses may also occur. In general, a 150 to 600 nm thick layer of silicon oxide will be provided in the first oxidation step and a 200 to 800 nm thick layer of silicon oxide will be provided with the oxidation step for the formation of the field oxide regions.

As a result of the formation of the oxide layers forces are exerted on the spacers 11 for pushing them away from the substrate surface. The manufacture according to the invention of the spacers of silicon oxynitride has the advantage that the mechanical forces acting hereon are absorbed by the silicon oxynitride in such a manner that the spacers are not pushed away or are substantially not pushed away from the substrate surface.

After the formation of the field oxide regions 7 the mask of silicon oxynitride and silicon nitride mask **as well as the remaining parts of the spacers 11** will in general be removed in a manner known in practice, after which the individual semiconductor elements, for example, transistors, diodes, etc., are formed in the active regions 8. Because in general several oxidation steps and etching steps are carried out the thickness of the formed field oxide regions 7 will generally decrease by another approximately 100 nm. In practice it is therefore advantageous to form field oxide regions which extend approximately 100 nm above the substrate surface. The field oxide projecting above the substrate surface will be removed at the end of the manufacturing steps so that sunken field oxide regions result having a substantially flat topography so that the electric wiring tracks for connection or interconnection of the individual semiconductor elements can relatively simply be provided.

In accordance with a further embodiment of the method according to the invention the first layer of silicon oxide is for this purpose formed in a thickness smaller than the thickness of the ultimate field oxide regions. Assuming that partially sunken oxide layers should be provided which again extend in the substrate over a depth of approximately 400 nm and moreover over a distance of approximately 100 nm above the substrate surface, a first oxide layer is formed in a thickness of approximately 300 nm. After etching this results in approximately 150 nm deep recesses in the silicon substrate determined by the mask. In the next oxidation step an approximately 500 nm thick oxide layer is then provided which extends over a distance of approximately 400 nm in the substrate and over approximately 100 nm above the substrate surface (not shown). What is surprising in this embodiment of the method according to the invention is that with the first oxidation step only an approximately 300 nm thick oxide layer need be formed, in contrast with the approximately 400 nm thick first oxide layer as described. This means that less deep recesses need be etched in the silicon substrate as a result of which the ultimate lateral oxide growth is less than 100 nm.

## Claims

1. A method of manufacturing a semiconductor device comprising a silicon substrate (1) with fully or partly sunken field oxide regions (7) for mutual insulation of semiconductor elements to be formed in the substrate (1), in which method a mask is formed in a layer of silicon oxynitride SiOₓN_{y} (2) deposited upon a surface of the substrate and an overlying layer of silicon nitride Si₃N₄ (3), whereby in the layer of silicon oxynitride (2) x/y is smaller than 0.5, after which, using said mask, recesses (6) are first provided in the substrate (1) in which recesses (6) the field oxide regions (7) are then formed by subjecting the recesses (6) over their whole area to an oxidation treatment, **characterized in that** the recesses (6) are provided in the substrate (1) by performing a first oxidation and then etching away the silicon oxide (5) thus formed, and **in that** prior to performing the first oxidation step a further layer of silicon oxynitride SiOₓN_{y} (9) is provided on the mask after which the said further layer of silicon oxynitride (9) is etched anisotropically in such a manner that the edges of the apertures of the mask (10) which bound the regions of the substrate (1) where the recesses (6) are provided remain covered with parts of the said further layer of silicon oxynitride (11).

2. The method as claimed in Claim 1, **characterized in that** the further silicon oxynitride layer (9) is provided in a thickness of 40 to 60 nm.

## Patentansprüche

1. Verfahren zur Herstellung einer Halbleiteranordnung mit einem Siliciumsubstrat (1) mit völlig oder teilweise versenkten Feldoxidgebieten (7) zur gegenseitigen Isolation von in dem Substrat (1) auszubildenden Halbleiterelementen, in welchem eine Maske in einer, auf einer Oberfläche des Substrats aufgebrachten Schicht (2) aus Siliciumoxynitrid SiOₓN_{y} und einer darüber liegenden Schicht (3) aus Siliciumnitrid Si₃N₄ ausgebildet wird, wobei in der Schicht (2) aus Siliciumoxynitrid x/y kleiner als 0,5 ist, und im Anschluss daran in dem Substrat (1) unter Verwendung der Maske zuerst Vertiefungen (6) vorgesehen werden, in welchen dann die Feldoxidgebiete (7) ausgebildet werden, indem die Vertiefungen (6) in ihrer gesamten Fläche einer Oxidationsbehandlung unterworfen werden, **dadurch gekennzeichnet, dass** die Vertiefungen (6) in dem Substrat (1) vorgesehen werden, indem zuerst eine Oxidation durchgeführt und dann das auf diese Weise ausgebildete Siliciumoxid (5) durch Ätzung abgetragen wird, und dass vor Ausführen des ersten Oxidationsschrittes eine weitere Schicht (9) aus Siliciumoxynitrid SiOₓN_{y} auf der Maske vorgesehen und die weitere Schicht (9) aus Siliciumoxynitrid danach durch anisotropes Ätzen so abgetragen wird, dass die Ränder der Öffnungen der Maske (10), welche die Bereiche des Substrats (1), in welchen die Vertiefungen (6) vorgesehen sind, begrenzen, mit Teilen der weiteren Schicht (11) aus Siliciumoxynitrid bedeckt bleiben.

2. Verfahren nach Anspruch 1, **dadurch gekennzeichnet, dass** die weitere Siliciumoxynitridschicht (9) in einer Stärke von 40 bis 60 nm vorgesehen wird.

## Revendications

1. Procédé de fabrication d'un dispositif semi-conducteur comprenant un substrat de silicium (1) avec des régions d'oxyde de champ en tout ou en partie noyées (7) pour un isolement mutuel d'éléments semi-conducteurs à former dans le substrat (1), procédé dans lequel un masque est formé dans une couche d'oxynitrure de silicium SiOₓN_{y} (2) déposée sur une surface du substrat et une couche sur-jacente de nitrure de silicium Si₃N₄ (3), de telle sorte que, dans la couche d'oxynitrure de silicium (2), le rapport x/y soit plus petit que 0,5, après quoi, en utilisant ledit masque, des évidements (6) sont tout d'abord ménagés dans le substrat (1), évidements (6) dans lesquels les régions d'oxyde de champ (7) sont ensuite formées en soumettant les évidements (6) sur toute leur surface à un traitement d'oxydation, **caractérisé en ce que** les évidements (6) sont ménagés dans le substrat (1) en effectuant une première oxydation, puis en attaquant l'oxyde de silicium (5) ainsi formé, et **en ce que**, avant d'effectuer la première étape d'oxydation, une autre couche d'oxynitrure de silicium SiOₓN_{y} (9) est appliquée sur le masque, après quoi ladite autre couche d'oxynitrure de silicium (9) est attaquée de manière anisotrope de telle façon que les bords des ouvertures du masque (10) qui délimitent les régions du substrat (1) où les évidements (6) sont ménagés restent revêtus de parties de ladite autre couche d'oxynitrure de silicium (11).

2. Procédé selon la revendication 1, **caractérisé en ce que** l'autre couche d'oxynitrure de silicium (9) est ménagée sur une épaisseur de 40 à 60 nm.
